# EUROPEAN PATENT APPLICATION

(11) **EP 2 015 351 A1**
(43) Date of publication of application: **14.01.2009**
(21) Application number: 07742101.4
(22) Date of filing: 20.04.2007
(51) Int. Cl.: H01L 21/308, H01L 31/04

(54) **METHOD FOR MANUFACTURING SEMICONDUCTOR SUBSTRATE, SOLAR SEMICONDUCTOR SUBSTRATE, AND ETCHING LIQUID**

(30) Priority: 02.05.2006 JP 2006128453
(71) Applicant: Mimasu Semiconductor Industry Co., Ltd., Takasaki-shi, Gunma 370-3533 (JP); Space Energy Corporation, Taito-ku Tokyo 1100005 (JP)
(72) Inventor: TSUCHIYA, Masato, Takasaki-shi, Gunma 370-3521 (JP); MASHIMO, Ikuo, Takasaki-shi, Gunma 370-3521 (JP); KIMURA, Yoshimichi, Tokyo 110-0005 (JP)
(74) Representative: Grünecker, Kinkeldey, Stockmair & Schwanhäusser Anwaltssozietät
(86) International application number: PCT/JP2007/058666
(87) International publication number: WO 2007/129555

(57) **Abstract**

Provided are: a process for producing safely at low cost a semiconductor substrate excellent in photoelectric conversion efficiency, and stable in an etching rate and a pyramid shape, which is capable of uniformly forming a fine uneven structure with desired size suitable for a solar cell on the surface thereof; a semiconductor substrate for solar application having a uniform and fine pyramid-shaped uneven structure in a plane; and an etching solution for forming a semiconductor substrate having a uniform and fine uneven structure, which has a high stability at initial use. The process comprises etching a semiconductor substrate with the use of an alkaline etching solution containing at least one kind selected from the group consisting of carboxylic acids having a carbon number of 1 to 12 and having at least one carboxyl group in a molecule, salts thereof, and silicon, to thereby form an uneven structure on the surface of the semiconductor substrate.

## Description

### Technical Field

The present invention relates to a process for producing a semiconductor substrate having an uneven structure, which is used for a solar cell or the like, a semiconductor substrate for solar application, and an etching solution used in the process.

### Background Art

Recently, in order to enhance an efficiency of a solar cell, there is employed a process involving forming an uneven structure on a surface of a substrate to input incident light from the surface into the substrate efficiently. As a process for uniformly forming a fine uneven structure on the surface of the substrate, Non-patent Document 1 discloses a process involving performing anisotropic etching treatment using a mixed aqueous solution of sodium hydroxide and isopropyl alcohol with respect to the surface of a single crystal silicon substrate having a (100) plane on the surface, to form unevenness in a pyramid shape (quadrangular pyramid) composed of a (111) plane. However, this process has problems in waste water treatment, working environment, and safety because of the use of isopropyl alcohol. Further, the shape and size of unevenness are non-uniform, so it is difficult to form uniform fine unevenness in a plane.

As an etching solution, Patent Document 1 discloses an alkaline aqueous solution containing a surfactant, and Patent Document 2 discloses an alkaline aqueous solution containing a surfactant that contains octanoic acid or dodecyl acid as a main component.
Patent Document 1: JP11-233484A
Patent Document 2: JP 2002-57139A
Patent Document 3: WO 2006-046601
Non-patent Document 1: Progress in Photovoltaics: Research and Applications, Vol. 4, 435-438 (1996).

### Disclosure of the Invention

### Problems to be Solved by the Invention

It is an object of the present invention to provide: a safe and low-cost process for producing a semiconductor substrate excellent in a photoelectric conversion efficiency, and stable in an etching rate and a pyramid shape, which is capable of uniformly forming a fine uneven structure with a desired size preferable for a solar cell on the surface thereof; a semiconductor substrate for solar application having a uniform and fine pyramid-shaped uneven structure in a plane; and an etching solution for forming a semiconductor substrate having a uniform and fine uneven structure, which has a high stability at initial use.

### Means for Solving the Problems

The present inventors found an alkaline etching solution containing at least one kind selected from the group consisting of carboxylic acids having a carbon number of 12 or less and having at least one carboxyl group in one molecule, and salts thereof, as an etching solution excellent in a photoelectric conversion efficiency, which can uniformly form a fine uneven structure with a desired size preferable for a solar cell on the surface of a semiconductor substrate (Patent Document 3). However, according to further studies, a problem was found out that when a semiconductor silicon substrate is etched with the etching solution, silicon is dissolved into the etching solution to change a concentration of the dissolved silicon therein, so that the pyramid shape formed on the surface of the silicon substrate is changed, and a stable property thereof cannot be obtained.

As a result of intensive researches to solve the problems, it has been found that the use of an etching solution containing the carboxylic acids and preliminarily added silicon as the etching solution leads to a high stability at initial use and a stable etching rate, so that a thickness of a silicon substrate and a pyramid shape formed thereon are stable to realize stabilization in production, and thus the present invention has been completed.

More specifically, a process for producing a semiconductor substrate according to the present invention comprises etching a semiconductor substrate with an alkaline etching solution containing at least one kind selected from the group consisting of carboxylic acids having a carbon number of 1 to 12 and having at least one carboxyl group in one molecule, salts thereof, and silicon (Si), to thereby form an uneven structure on a surface of the semiconductor substrate.

It is preferable that the etching solution contains the dissolved silicon at an amount or more where a stable etching rate is obtained. The etching solution preferably contains the dissolved silicon at a concentration range of 1 % by weight to a saturated state. In the etching solution according to the present invention, a preferable aspect of containing silicon is in that the etching solution preliminarily contains at least one kind selected from the group consisting of metallic silicon, silica, silicic acid, and silicates.

The carboxylic acid is preferably one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid. In addition, the carbon number of the carboxylic acid is preferably 7 or less. A concentration of the carboxylic acid in the etching solution is preferably 0.05 to 5 mol/L.

By selecting a predetermined one or two or more kinds of carboxylic acids as the carboxylic acid in the etching solution, a size of a pyramid-shaped protrusion of an uneven structure formed on a surface of the semiconductor substrate can be regulated.

A semiconductor substrate for solar application of the present invention has an uneven structure on a surface, produced by the method according to the present invention.

Further, it is preferable that the semiconductor substrate for solar application of the present invention has a uniform and fine uneven structure in a pyramid shape on the surface of the semiconductor substrate, and the maximum side length of a bottom surface of the uneven structure is in a range of 1 µm to 30 µm. In the present invention, the maximum side length refers to an average value of one side length of a bottom surface of ten (10) uneven structures successively selected in a decreasing order of the shape size in the uneven structure per unit area of 265 µm x 200 µm.
The semiconductor substrate is preferably a thinned single crystal silicon substrate.

An etching solution of the present invention is for uniformly forming a fine uneven structure in a pyramid shape on a surface of a semiconductor substrate, which is an aqueous solution containing an alkali, a carboxylic acid with a carbon number of 12 or less having at least one carboxyl group in one molecule, and silicon.

In addition, the carboxylic acid is preferably one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid. The carbon number of the carboxylic acid is preferably 7 or less.

### Effects of the Invention

According to the process for producing a semiconductor substrate and an etching solution of the present invention, a semiconductor substrate which is excellent in a photoelectric conversion efficiency and a finely uniform uneven structure in a desired shape which is preferable for a solar cell can be produced safely at low cost. The etching solution is stable in an etching rate, excellent in stability and capable of forming a silicon substrate stable in a thickness and a pyramid shape formed thereon. The semiconductor substrate for solar application of the present invention has a uniform and fine uneven structure which is preferable for a solar cell and the like, and a solar cell excellent in a photoelectric conversion efficiency can be obtained by using the semiconductor substrate.

### Brief Description of the Drawings

FIG. 1 is a graph showing a relationship between an amount of the dissolved silicon and an etching rate in Experimental Example 1.
FIG. 2 is a graph showing a relationship between an amount of the dissolved silicon and a side length of a pyramid in Experimental Example 1.
FIG. 3 shows a picture of a result of an electron micrograph in case of an amount of the dissolved silicon being 0 g/L in Experimental Example 1.
FIG. 4 shows a picture of a result of an electron micrograph in case of an amount of the dissolved silicon being 2.0 g/L in Experimental Example 1.
FIG. 5 shows a picture of a result of an electron micrograph in case of an amount of the dissolved silicon being 3.9 g/L in Experimental Example 1.
FIG. 6 shows a picture of a result of an electron micrograph in case of an amount of the dissolved silicon being 5.7 g/L in Experimental Example 1.
FIG. 7 shows a picture of a result of an electron micrograph in case of an amount of the dissolved silicon being 5.7 g/L in Experimental Example 2.
FIG. 8 is a graph showing a relationship between an amount of the dissolved silicon and an etching rate in Experimental Example 3.
FIG. 9 shows a picture of a result of an electron micrograph in case of an amount of the dissolved silicon being 5.7 g/L in Experimental Example 3.
FIG. 10 shows a picture of a result of an electron micrograph in case of an amount of the dissolved silicon being 5.7 g/L in Experimental Example 4.
FIG. 11 is a graph showing a relationship between an amount of the dissolved silicon and an etching rate in Experimental Example 5.
FIG. 12 shows a picture of a result of an electron micrograph in case of an amount of the dissolved silicon being 5.7 g/L in Experimental Example 5.
FIG. 13 shows a picture of a result of an electron micrograph in case of an amount of the dissolved silicon being 5.7 g/L in Experimental Example 6.
FIG. 14 is a graph showing a relationship between an amount of the dissolved silicon and an etching rate in Experimental Example 7.
FIG. 15 shows a picture of a result of an electron micrograph in case of an amount of the dissolved silicon being 5.7 g/L in Experimental Example 7.
FIG. 16 shows a picture of a result of an electron micrograph in case of an amount of the dissolved silicon being 5.7 g/L in Experimental Example 8.

### Best Mode for Carrying out the Invention

Hereinafter, embodiments of the present invention will be described. However, these embodiments will be shown for illustrative purposes, and it is needless to say that they can be variously modified without departing from the technical idea of the present invention.

According to the process for producing a semiconductor substrate of the present invention, an alkaline solution containing at least one kind of carboxylic acids having a carbon number of 12 or less and having at least one carboxyl group in one molecule, salts thereof, and silicon is used as an etching solution, and a semiconductor substrate is soaked in the etching solution to subject the surface of the substrate to anisotropic etching, whereby a uniform and fine uneven structure is formed on the surface of the substrate.

As the above-mentioned carboxylic acid, known organic compounds each having a carbon number of 12 or less and having at least one carboxyl group in one molecule can be used widely. Although the number of carboxyl groups is not particularly limited, it is preferably 1 to 3. That is, monocarboxylic acids, dicarboxylic acids, and tricarboxylic acids are preferable. The carbon number of a carboxylic acid is 1 or more, preferably 2 or more, and more preferably 4 or more, and 12 or less, preferably 10 or less, and more preferably 7 or less. As the above-mentioned carboxylic acid, although any of chain carboxylic acids and cyclic carboxylic acids can be used, a chain carboxylic acid is preferable, and in particular, a chain carboxylic acid having a carbon number of 2 to 7 is preferable.

Examples of the chain carboxylic acid include: saturated chain monocarboxylic acids (saturated fatty acids) such as formic acid, acetic acid, propanoic acid, butanoic acid, pentanoic acid, hexanoic acid, heptanoic acid, octanoic acid, nonanoic acid, decanoic acid, undecanoic acid, dodecanoic acid, and isomers thereof; aliphatic saturated dicarboxylic acids such as oxalic acid, malonic acid, succinic acid, glutaric acid, adipic acid, pimelic acid, and isomers thereof; aliphatic saturated tricarboxylic acids such as propanetricarboxylic acid and methanetriacetic acid; unsaturated fatty acids such as acrylic acid, butenoic acid, pentenoic acid, hexenoic acid, heptenoic acid, pentadienoic acid, hexadienoic acid, heptadienoic acid, and acetylenecarboxylic acid; aliphatic unsaturated dicarboxylic acids such as butenedioic acid, pentenedioic acid, hexenedioic acid, hexenedioic acid, and acetylenedicarboxylic acid; and aliphatic unsaturated tricarboxylic acids such as aconitic acid.

Examples of the cyclic carboxylic acids include: alicyclic carboxylic acids such as cyclopropanecarboxylic acid, cyclobutanecarboxylic acid, cyclopentanecarboxylic acid, hexahydrobenzoic acid, cyclopropanedicarboxylic acid, cyclobutanedicarboxylic acid, cyclopentanedicarboxylic acid, cyclopropanetricarboxylic acid, and cyclobutanetricarboxylic acid; and aromatic carboxylic acids such as benzoic acid, phthalic acid, and benzenetricarboxylic acid.

In addition, carboxyl group-containing organic compounds each having a functional group other than a carboxyl group can also be used. Examples thereof include: oxycarboxylic acids such as glycolic acid, lactic acid, hydroacrylic acid, oxybutyric acid, glyceric acid, tartronic acid, malic acid, tartaric acid, citric acid, salicylic acid, and gluconic acid; ketocarboxylic acids such as pyruvic acid, acetoacetic acid, propionylacetic acid, and levulinic acid; and alkoxycarboxylic acids such as methoxycarboxylic acid and ethoxyacetic acid.

Preferable examples of the those carboxylic acids include acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

As the carboxylic acid in the etching solution, a carboxylic acid containing at least one carboxylic acid having a carbon number of 4 to 7 as a main component is preferable, and if required, it is preferable to add a carboxylic acid having a carbon number of 3 or less or a carboxylic acid having a carbon number of 8 or more.
The concentration of carboxylic acid in the etching solution is preferably 0.05 to 5 mol/L, and more preferably 0.2 to 2 mol/L.

In the production process of the present invention, by selecting a predetermined carboxylic acid, the size of an uneven structure to be formed on the surface of a semiconductor substrate can be varied. In particular, by using an etching solution mixed with a plurality of carboxylic acids having different carbon numbers, the size of pyramid-shaped protrusions of the uneven structure on the surface of the substrate can be regulated. As the carbon number of a carboxylic acid to be added is smaller, the size of the uneven structure becomes smaller. In order to uniformly form fine unevenness, it is preferable that the carboxylic acid to be added contain one or two or more kinds of aliphatic carboxylic acids with a carbon number of 4 to 7 as main components, and if required, other carboxylic acids.

The process of preparing an etching solution containing silicon according to the present invention is not particularly limited; however, a preferable aspect of containing silicon is in that the etching solution preliminarily contains such as metallic silicon, silica, silicic acid, and silicates. The concentration of silicon in the etching solution is preferably 1 % by weight or more, more preferably 2 % by weight or more. There is no upper limit for an adding amount of silicon, and an etching solution containing saturated state of silicon may be used.
Silicates of alkali metals are preferable for the above-mentioned silicates. The examples include: sodium silicates such as sodium orthosilicate (Na₄SiO₄·nH₂O) and sodium metasilicate (Na₂SiO₃·H₂O); potassium silicates such as K₄SiO₄·nH₂O and K₂SiO₃·nH₂O; and lithium silicates such as Li₄SiO₄·nH₂O and Li₂SiO₃·nH₂O.

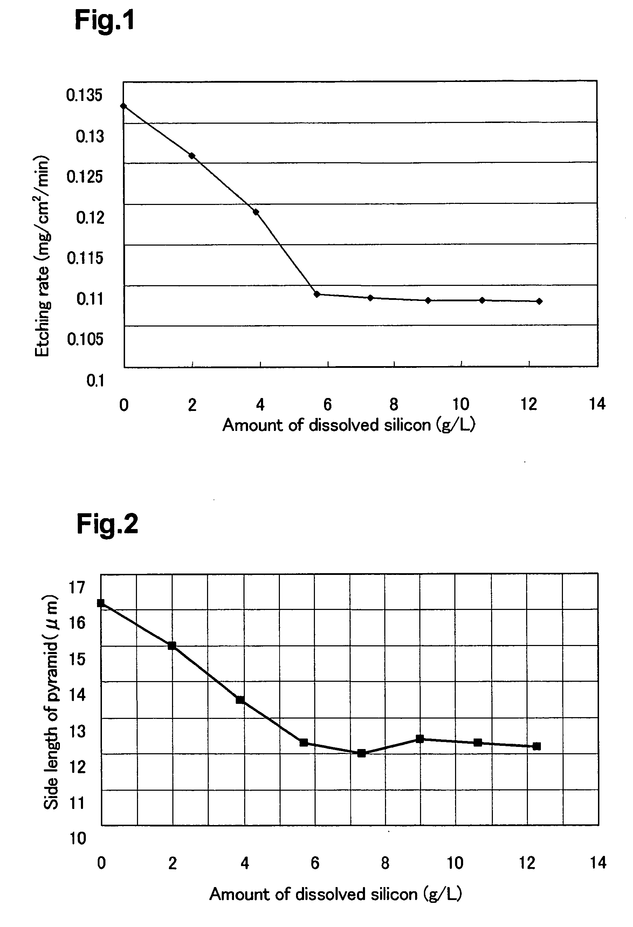

In the etching solution according to the present invention, by adding silicon at a predetermined amount or more, as shown in FIG. 1, a stable etching rate can be obtained to stabilize a thickness of the silicon substrate and a pyramid shape formed thereon. Therefore, it is preferable that silicon is added at an amount or more where a stable etching rate is obtained. Since the amount of silicon where a stable etching rate is obtained is variable depending on an alkali concentration and an etching temperature, the amount may be determined by conditions. For example, under the conditions of a KOH concentration of 25 % and a temperature of 90 °C, silicon is preferably added at a concentration of 4 g/L or more, and more preferably 5.5 g/L or more.

As the above-mentioned alkaline solution, there is an aqueous solution in which an alkali is dissolved. As the alkalies, any of an organic alkali and an inorganic alkali can be used. As the organic alkali, for example, a quaternary ammonium salt such as tetramethylammonium hydroxide and ammonia are preferable. As the inorganic alkali, hydroxides of alkali metals or alkaline earth metals such as sodium hydroxide, potassium hydroxide, and calcium hydroxide are preferable, and sodium hydroxide or potassium hydroxide is particularly preferable. Those alkalies may be used alone or in combination of at least two kinds. The alkali concentration in the etching solution is preferably 3 to 50% by weight, more preferably 5 to 30% by weight, and further preferably 8 to 25% by weight.

As the above-mentioned semiconductor substrate, although a single crystal silicon substrate is preferable, a semiconductor substrate of a single crystal using a semiconductor compound such as germanium and gallium arsenide can also be used.

In the process of the present invention, an etching process is not particularly limited. For example, a semiconductor substrate is soaked for a predetermined period of time, using an etching solution heated to be kept at a predetermined temperature, whereby a uniform and fine uneven structure is formed on the surface of the semiconductor substrate. The temperature of the etching solution is not particularly limited, a range of 70°C to 98°C being preferable. The etching time is also not particularly limited, a range of 15 to 30 minutes being preferable.

According to the process for producing a semiconductor substrate of the present invention, a semiconductor substrate with a uniform uneven structure in a pyramid shape can be obtained, in which the maximum side length of a bottom surface is 1 µm to 30 µm, with an upper limit value thereof being preferably 20 µm, more preferably 10 µm, and a vertical angle of a vertical cross section is 110°. Further, according to the present invention, a semiconductor substrate with a low reflectivity can be obtained at low cost.

### Examples

Hereinafter, the present invention will be described more specifically by way of examples. However, it should be appreciated that these examples are shown for illustrative purposes, and should not be interpreted in a limiting manner.

### (Experimental Example 1)

Using an etching solution, in which 50 g/L (0.43 mol/L) of hexanoic acid and a predetermined amount of potassium silicate (the amount of dissolved silicon ; 0, 2.0, 3.9, 5.7, 7.3, 9.0, 10.6 or 12.3 g/L) were added to a 25% by weight KOH aqueous solution, as an etching solution, a single crystal silicon substrate (a square plate with a side of 126mm and a thickness of 200µm) having a (100) plane on a surface thereof was soaked at 90°C for 30 minutes. Then, a reduced amount of the etched silicon substrate was measured to calculate an etching rate. In addition, the surface of the etched substrate was observed in a scanning electron microscope to measure a side length of a pyramid. Herein, the side length of the pyramid refers to an average value of one side length (a maximum side length of a base) measured of 10 uneven structures successively selected in a decreasing order of the shape size in the uneven structure per unit area of 265 µm × 200 µm.

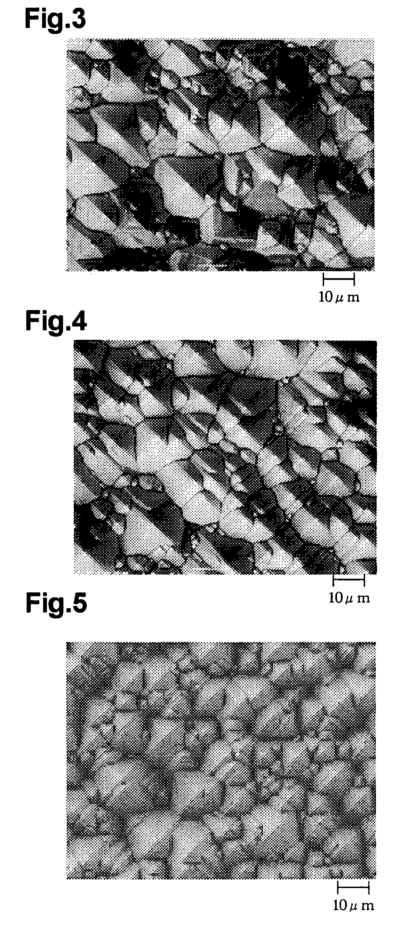

FIG. 1 is a graph showing a relationship between the amount of the dissolved silicon and the etching rate. FIG. 2 is a graph showing a relationship between the amount of the dissolved silicon and the side length of the pyramid. FIGS. 3 to 6 show pictures of results of scanning electron micrographs (a magnification of 1,000) in case of the amounts of the dissolved silicon being 0, 2.0, 3.9, or 5.7 g/L, respectively.

As shown in FIGS. 1 to 6, by dissolving silicon into an alkaline solution in which hexanoic acid was added, a stable etching rate is obtained to stabilize a thickness of the silicon substrate and a pyramid shape formed thereon.

### (Experimental Example 2)

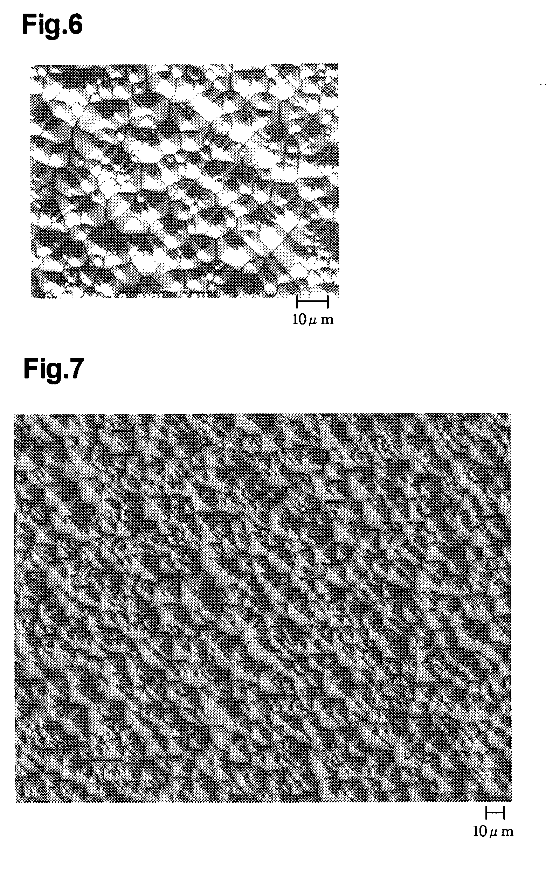

As a result of conducting an experiment in the same way as in Experimental Example 1 except that the concentration of the KOH aqueous solution was changed to 12.5% by weight to calculate an etching rate, the same result as Experimental Example 1 was obtained.
Further, in case of the amount of the dissolved silicon being 5.7 g/L, the etched substrate surface was observed by a scanning electron microscope to measure a side length of a pyramid, and the side length of the pyramid was 10µm. The obtained scanning electron micrograph (a magnification of 500) is shown in FIG. 7.

### (Experimental Example 3)

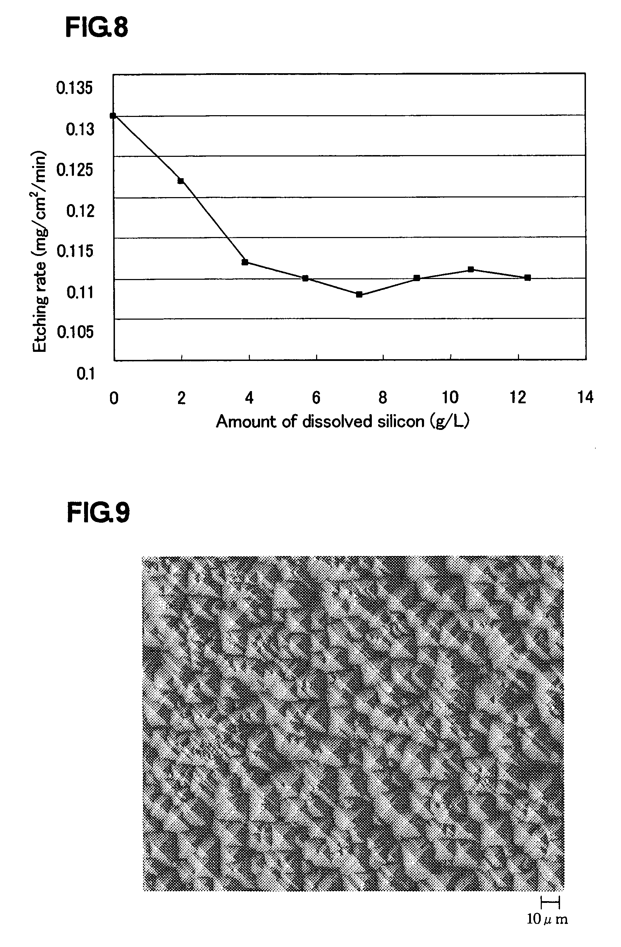

An experiment was conducted in the same way as in Experimental Example 1 except that the etching solution in which 50 g/L (0.35 mol/L) of octanoic acid was added in place of hexanoic acid to calculate an etching rate. The result is shown in FIG. 8. As shown in FIG. 8, by dissolving silicon into an alkaline solution in which octanoic acid was added, a stable etching rate was obtained.
Further, in case of the amount of the silicon dissolution being 5.7 g/L, the etched substrate surface was observed by a scanning electron microscope to measure a side length of a pyramid, the side length of the pyramid was 15µm. The obtained scanning electron micrograph (a magnification of 500) is shown in FIG. 9.

### (Experimental Example 4)

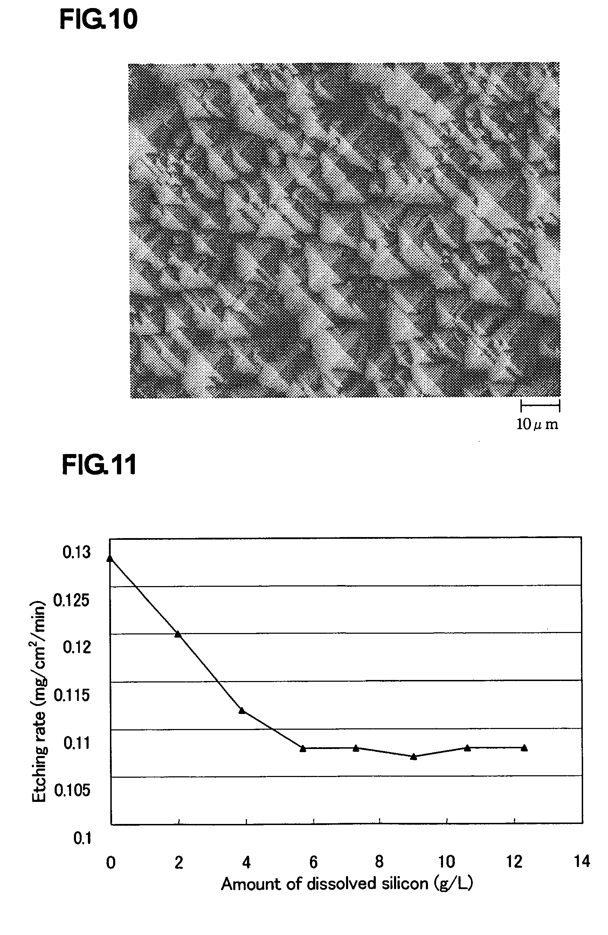

As a result of conducting an experiment in the same way as in Experimental Example 3 except that the concentration of the KOH aqueous solution was changed to 12.5% by weight to calculate an etching rate, same result as Experimental Example 3 was obtained.
Further, in case of an amount of the silicon dissolution being 5.7 g/L, the etched substrate surface was observed by a scanning electron microscope to measure a side length of a pyramid, the side length of the pyramid was 13µm. The obtained scanning electron micrograph (a magnification of 1000) is shown in FIG. 10.

### (Experimental Example 5)

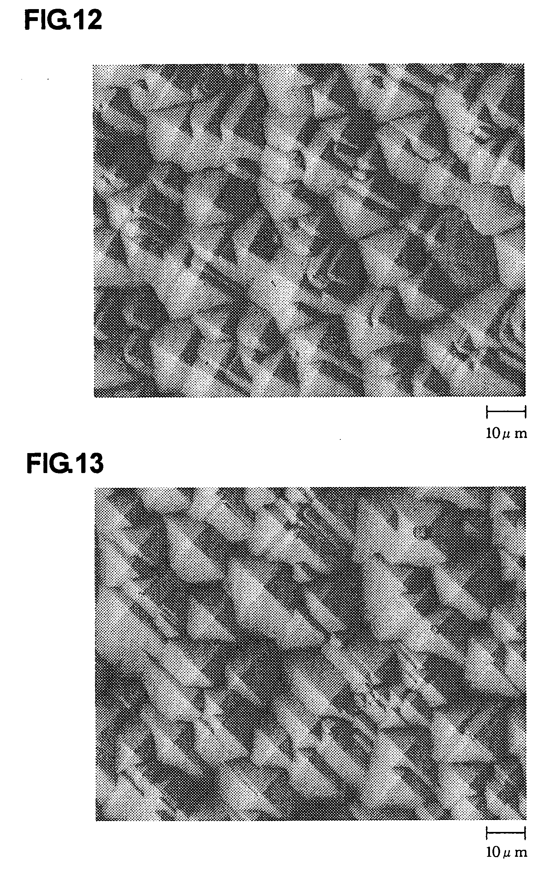

An experiment was conducted in the same way as in Experimental Example 1 except that the etching solution in which 50 g/L (0.29 mol/L) of decanoic acid was added in place of hexanoic acid to calculate an etching rate. The result is shown in FIG. 11. As shown in FIG. 11, by dissolving silicon into an alkaline solution in which decanoic acid was added, a stable etching rate was obtained.
Further, in case of an amount of the silicon dissolution being 5.7 g/L, the etched substrate surface was observed by a scanning electron microscope to measure a side length of a pyramid, the side length of the pyramid was 18 µm. The obtained scanning electron micrograph (a magnification of 1000) is shown in FIG. 12.

### (Experimental Example 6)

As a result of conducting an experiment in the same way as in Experimental Example 5 except that the concentration of the KOH aqueous solution was changed to 12.5% by weight to calculate an etching rate, same result as Experimental Example 5 was obtained.
Further, in case of an amount of the dissolved silicon being 5.7 g/L, the etched substrate surface was observed by a scanning electron microscope to measure a side length of a pyramid, the side length of the pyramid was 16µm. The obtained scanning electron micrograph (a magnification of 1000) is shown in FIG. 13.

### (Experimental Example 7)

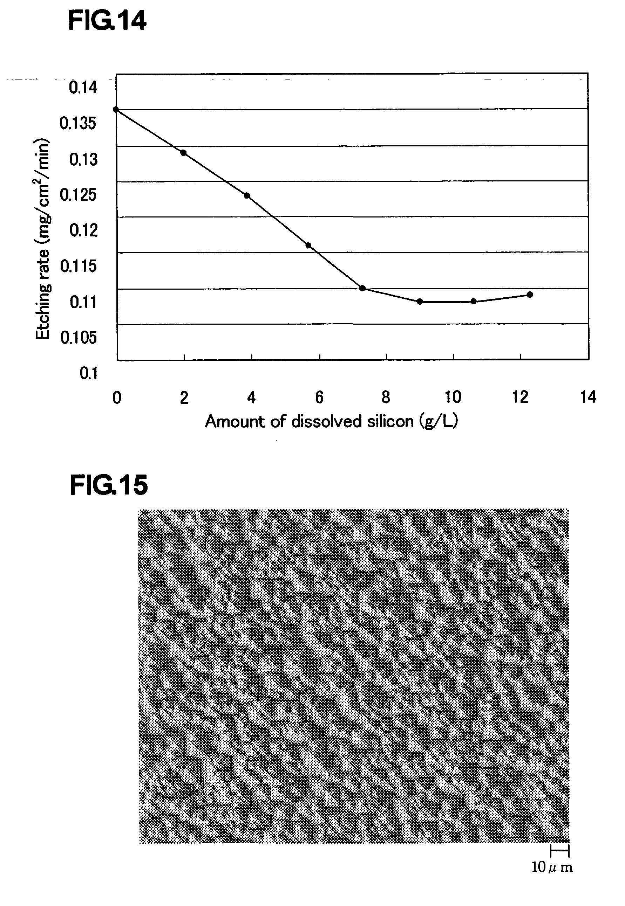

An experiment was conducted in the same way as in Experimental Example 1 except that the etching solution in which 50 g/L (0.49 mol/L) of pentanoic acid was added in place of hexanoic acid to calculate an etching rate. The result is shown in FIG. 14. As shown in FIG. 14, by dissolving silicon into an alkaline solution in which pentanoic acid was added, a stable etching rate was obtained.
Further, in case of an amount of the dissolved silicon being 5.7 g/L, the etched substrate surface was observed by a scanning electron microscope to measure a side length of a pyramid, the side length of the pyramid was 9 µm. The obtained scanning electron micrograph (a magnification of 500) is shown in FIG. 15.

### (Experimental Example 8)

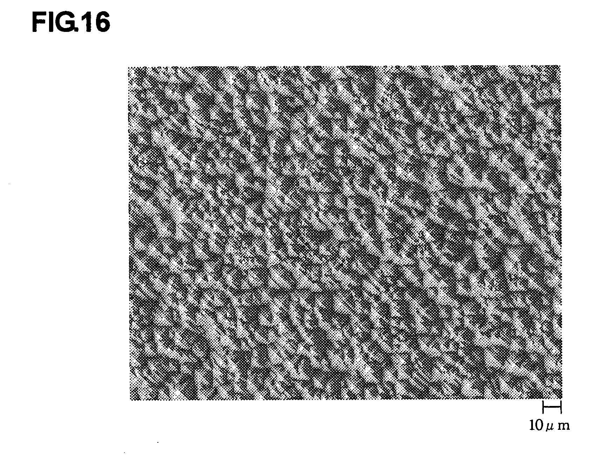

As a result of conducting an experiment in the same way as in Experimental Example 7 except that the concentration of the KOH aqueous solution was changed to 12.5% by weight to calculate an etching rate, the same result as Experimental Example 7 was obtained.
Further, in case of an amount of dissolved silicon being 5.7 g/L, the etched substrate surface was observed by a scanning electron microscope to measure a side length of a pyramid, the side length of the pyramid was 8µm. The obtained scanning electron micrograph (a magnification of 500) is shown in FIG. 16.

## Claims

1. A process for producing a semiconductor substrate, comprising etching a semiconductor substrate with an alkaline etching solution containing at least one kind selected from the group consisting of carboxylic acids having a carbon number of 1 to 12 and having at least one carboxyl group in one molecule, salts thereof, and silicon, to thereby form an uneven structure on a surface of the semiconductor substrate.

2. The process for producing a semiconductor substrate according to claim 1, wherein the etching solution contains the dissolved silicon at an amount or more where a stable etching rate is obtained.

3. The process for producing a semiconductor substrate according to claim 1 or 2, wherein the etching solution contains the dissolved silicon at a concentration range of 1 % by weight to a saturated state.

4. The process for producing a semiconductor substrate according to any one of claims 1 to 3, wherein the etching solution preliminarily contains at least one kind selected from the group consisting of metallic silicon, silica, silicic acid, and silicates.

5. The process for producing a semiconductor substrate according to any one of claims 1 to 4, wherein the carboxylic acid is one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

6. The process for producing a semiconductor substrate according to any one of claims 1 to 5, wherein the carbon number of the carboxylic acid is 7 or less.

7. The process for producing a semiconductor substrate according to any one of claims 1 to 6, wherein a concentration of the carboxylic acid in the etching solution is 0.05 to 5 mol/L.

8. The process for producing a semiconductor substrate according to any one of claims 1 to 7, wherein by selecting a predetermined one or two or more kinds of carboxylic acids as the carboxylic acid in the etching solution, a size of a pyramid-shaped protrusion of an uneven structure formed on a surface of the semiconductor substrate is regulated.

9. A semiconductor substrate for solar application comprising an uneven structure on a surface thereof, which is produced by the method according to any one of claims 1 to 8.

10. The semiconductor substrate for solar application according to claim 9, further comprising a uniform and fine uneven structure in a pyramid shape on the surface thereof, wherein the uneven structure has a bottom surface which has a maximum side length of 1 µm to 30 µm.

11. The semiconductor substrate for solar application according to claim 9 or 10, wherein the semiconductor substrate is a thinned single crystal silicon substrate.

12. An etching solution for uniformly forming a fine uneven structure in a pyramid shape on a surface of a semiconductor substrate, which is an aqueous solution containing an alkali, a carboxylic acid having a carbon number of 12 or less and having at least one carboxyl group in one molecule, and silicon.

13. The etching solution according to claim 12, wherein the carboxylic acid is one or two or more kinds selected from the group consisting of acetic acid, propionic acid, butanoic acid, pentanoic acid, hexanoic acid, heptanoic acid, octanoic acid, nonanoic acid, decanoic acid, undecanoic acid, dodecanoic acid, acrylic acid, oxalic acid, and citric acid.

14. The etching solution according to claim 12 or 13, wherein the carboxylic acid has a carbon number of 7 or less.
